# EUROPÄISCHE PATENTANMELDUNG

(11) **EP 4 303 383 A1**
(43) Veröffentlichungstag der Anmeldung: **10.01.2024**
(21) Anmeldenummer: 23020331.7
(22) Anmeldetag: 04.07.2023
(51) Int. Cl.: E05B 13/10

(54) **ELEKTROMECHANISCHE VERSCHLUSSBAUGRUPPE FÜR EINE TÜR**

(30) Priorität: 06.07.2022 DE 102022116915
(71) Anmelder: Fath Mechatronics GmbH, 91174 Spalt (DE)
(72) Erfinder: Sept, Jürgen, 91187 Röttenbach (DE); Nettner, Peter, 91180 Heideck (DE)
(74) Vertreter: Schneider, Andreas

(57) **Zusammenfassung**

Die Erfindung betrifft eine elektromechanische Verschlußbaugruppe für eine Tür. Dabei befinden sich alle elektrischen bzw. elektronischen Bauteile in einem staubdicht und wasserdicht gekapselten Elektronikbauraum, der in einem Verschlußgehäuse an der Türaußenseite angeordnet ist. Die Baugruppe ist an Türen mit den beiden gängigsten Lochbildern montierbar, sowie auch in Kombination mit einem Stangenschloß. Eine zusätzlich äußere Abdeckung des Schließzylinders ist nicht erforderlich.

## Beschreibung

Die Erfindung betrifft eine elektromechanische Verschlußbaugruppe für eine Tür. Insbesondere betrifft die Erfindung einen Schwenkhebelverschluß mit einem Schwenkhebelgriff und einer elektromotorisch betätigbaren Mechanik.

Vor allem bei der Anwendung in sicherheitskritischen Bereichen, beispielsweise bei der Sicherung von Serverschränken, sind Schwenkhebelverschlüsse in vielen Fällen wasserdicht ausgeführt. Dies ist insbesondere auch dann notwendig, wenn die Schwenkhebelverschlüsse elektromotorisch betätigbare Komponenten enthalten, damit die Funktionssicherheit nicht durch den Eintritt von Feuchtigkeit beeinträchtigt wird. Öffnungen an der Vorderseite des Verschlusses, beispielsweise an einem Schließzylinder, müssen dann mit Hilfe zusätzlicher Bauteile abgedichtet werden. Beispielsweise werden Schließzylinder mit einer schwenkbaren oder schiebbaren Abdeckung versehen. Aufgrund dieser zusätzlichen beweglichen Komponenten erhöht sich die Fehleranfälligkeit des Verschlusses. Darüber hinaus stehen derartige Abdeckungen oftmals einer ergonomischen Bedienung des Verschlusses entgegen.

Aufgrund des zusätzlichen Bedarfes an Bauraum für die Unterbringung der elektrischen und/oder elektronischen Komponenten eines elektromechanischen Schwenkhebelverschlusses lassen sich außerdem diese Verschlüsse oftmals nicht universell einsetzen. Teilweise werden für die Montage solcher Verschlüsse nichtstandardisierte Montageöffnungen benötigt, was einen einfachen Austausch von Verschlüssen, insbesondere das Ersetzen manuell betätigbarer Verschlüsse durch elektromotorisch betätigbare Verschlüsse behindert. Zudem weisen bekannte elektromechanische Schwenkhebelverschlüsse oftmals unvorteilhafte ergonomische Eigenschaften auf.

Eine Aufgabe der vorliegenden Erfindung ist es, einen ergonomisch vorteilhaften, möglichst universell einsetzbaren, elektromotorisch betätigbaren Schwenkhebelverschluß bereitzustellen. Diese Aufgabe wird durch eine Verschlußbaugruppe nach Anspruch 1 gelöst. Vorteilhafte Ausführungen der Erfindung sind in den Unteransprüchen angegeben.

Die erfindungsgemäße elektromechanische Verschlußbaugruppe umfaßt ein Verschlußgehäuse, das mit seiner Unterseite auf eine Seite der Tür aufsetzbar ist, dabei vorzugsweise die äußeren Ränder einer oder mehrerer in der Tür vorgesehener Montageöffnungen überdeckend, eine erste Verriegelungseinrichtung zum Verriegeln der Tür, wobei die erste Verriegelungseinrichtung einen Schwenkhebelgriff aufweist, der vorzugsweise in seiner Ruhestellung in einer Aufnahme des Verschlußgehäuses aufgenommen ist, und eine zweite Verriegelungseinrichtung zum Verriegeln des Schwenkhebelgriffs, wobei diese zweite Verriegelungseinrichtung ein elektromotorisch betätigbares Verriegelungselement aufweist, wobei Teile der ersten Verriegelungseinrichtung über die Unterseite des Verschlußgehäuses hinausragen, so daß Teile der ersten Verriegelungseinrichtung sowohl in einem ersten äußeren Bauraum innerhalb des Verschlußgehäuses als auch in einem mit dem ersten äußeren Bauraum in Verbindung stehenden ersten inneren Bauraum auf der dem Verschlußgehäuse gegenüberliegenden Seite der Tür angeordnet sind, und wobei Teile der zweiten Verriegelungseinrichtung über die Unterseite des Verschlußgehäuses hinausragen, so daß Teile der zweiten Verriegelungseinrichtung sowohl in einem zweiten äußeren Bauraum innerhalb des Verschlußgehäuses als auch in einem mit dem zweiten äußeren Bauraum in Verbindung stehenden zweiten inneren Bauraum auf der dem Verschlußgehäuse gegenüberliegenden Seite der Tür angeordnet sind, und wobei Teile der zweiten Verriegelungseinrichtung in einem dritten äußeren Bauraum innerhalb des Verschlußgehäuses angeordnet sind, welcher dritte äußere Bauraum zwischen dem ersten äußeren Bauraum und dem zweiten äußeren Bauraum angeordnet ist, wobei die in dem dritten äußeren Bauraum angeordneten Teile der zweiten Verriegelungsvorrichtung nicht über die Unterseite des Verschlußgehäuses hinausragen, so daß sie keinen Bauraum auf der dem Verschlußgehäuse gegenüberliegenden Seite der Tür beanspruchen, wodurch auf der dem Verschlußgehäuse gegenüberliegenden Seite der Tür ein Freiraum zwischen dem ersten inneren Bauraum und dem zweiten inneren Bauraum verbleibt, der eine Montage der Verschlußbaugruppe sowohl bei einer Tür mit einer einzigen durchgehenden Montageöffnung, insbesondere mit einer rechteckförmigen Montageöffnung mit einer Breite von 25 mm und einer Länge von 150 mm, als auch bei einer Tür mit zwei Montageöffnungen erlaubt, insbesondere mit zwei senkrecht zueinander ausgerichteten und in einem Abstand von 50 mm angeordneten, rechteckförmigen Montageöffnungen mit einer Breite von 25 mm und mit einer Länge von 50 mm.

Auf diese Weise wird ein ergonomisch vorteilhafter, universell einsetzbarer, elektromotorisch betätigbarer Schwenkhebelverschluß bereitgestellt.

Die Verschlußbaugruppe eignet sich insbesondere für technische Schränke, wie Serverracks, Schaltschränke und Cabinets, sowohl im Innen- als auch im Außenbereich. Es ist für alle Bereiche einsetzbar, die gesichert werden müssen, wie z. B. Rechenzentren, Schaltschränke an Produktionsanlagen oder in kritischer Infrastruktur. Dabei können herkömmliche Verschlußbaugruppen, insbesondere rein manuell betätigbare Verschlüsse, leicht durch die erfindungsgemäße elektromechanische Verschlußbaugruppe ersetzt werden. Die Baugruppe kann in Verbindung mit verschiedenen Schloßarten eingesetzt werden, insbesondere mit allen Arten von Treibriegelschlössern mit Riegeln oder Stangen jeglicher Art als Verriegelungselemente.

Die Erfindung ermöglicht die Bereitstellung eines Schwenkhebelverschlusses, bei dem sich, bis auf die gegebenenfalls im zweiten Verriegelungsbauraum angeordneten Sensoren, im wesentliche alle elektrischen bzw. elektronischen Bauteile der Baugruppe in dem Elektronikbauraum, also dem dritten äußeren Bauraum befinden, der sich, vorzugsweise staubdicht und wasserdicht gekapselt, im Verschlußgehäuse und damit an der Türaußenseite, also vor der zu verschließenden Tür befindet. Die erfindungsgemäße Baugruppe besitzt daher neben der Montierbarkeit in einem 150 mm x 25 mm-Türausschnitt nicht nur eine zusätzliche Kompatibilität mit der 50 mm x 25 mm Türausschnitt-Variante, beides auch in Verbindung mit einem Stangenschloß, sondern es ist gleichzeitig auch möglich, auf eine zusätzlich äußere Abdeckung des Schließzylinders zu Abdichtungszwecken zu verzichten. Hierdurch reduziert sich nicht nur die Anzahl der beweglichen mechanischen Komponenten der Baugruppe, wodurch sich auch die Fehleranfälligkeit verringert. Neben der auf diese Weise erhöhten Funktionssicherheit kann auch die Vorderseite der Baugruppe, insbesondere die Gestaltung des Verschlußgehäuses und des Schwenkhebelgriffs auf besonders ergonomische Weise ausgeführt werden.

Gemäß einer bevorzugten Ausführungsform der Erfindung ragen Teile der zweiten Verriegelungseinrichtung über die Unterseite des Verschlußgehäuses hinaus, so daß Teile der zweiten Verriegelungseinrichtung sowohl in einem zweiten äußeren Bauraum innerhalb des Verschlußgehäuses als auch in einem mit dem zweiten äußeren Bauraum in Verbindung stehenden zweiten inneren Bauraum auf der dem Verschlußgehäuse gegenüberliegenden Seite der Tür angeordnet sind.

Gemäß einer bevorzugten Ausführungsform der Erfindung sind Teile der zweiten Verriegelungseinrichtung in einem dritten äußeren Bauraum innerhalb des Verschlußgehäuses angeordnet, welcher dritte äußere Bauraum zwischen dem ersten äußeren Bauraum und dem zweiten äußeren Bauraum angeordnet ist. Dabei ragen die in dem dritten äußeren Bauraum angeordneten Teile der zweiten Verriegelungsvorrichtung nicht über die Unterseite des Verschlußgehäuses hinaus, so daß sie keinen Bauraum auf der dem Verschlußgehäuse gegenüberliegenden Seite der Tür beanspruchen, insbesondere keinen Bauraum zwischen dem ersten inneren Bauraum und dem zweiten inneren Bauraum. Hierdurch verbleibt auf der dem Verschlußgehäuse gegenüberliegenden Seite der Tür ein Freiraum zwischen dem ersten inneren Bauraum und dem zweiten inneren Bauraum, der eine Montage der Verschlußbaugruppe sowohl bei einer Tür mit einer einzigen durchgehenden Montageöffnung, insbesondere mit einer rechteckförmigen Montageöffnung mit einer Breite von 25 mm und einer Länge von 150 mm, als auch bei einer Tür mit zwei Montageöffnungen erlaubt, insbesondere mit zwei senkrecht zueinander ausgerichteten und in einem Abstand von 50 mm angeordneten, rechteckförmigen Montageöffnungen mit einer Breite von 25 mm und mit einer Länge von 50 mm. Die beiden Montageöffnungen erlauben dabei sowohl die Aufnahme des ersten Verriegelungsbauraums, der gemeinsam von dem ersten äußeren Bauraum und dem ersten inneren Bauraum gebildet wird, als auch die Aufnahme des zweiten Verriegelungsbauraums, der gemeinsam von dem zweiten äußeren Bauraum und dem zweiten inneren Bauraum gebildet wird, in der Tür bzw. das Hindurchführen der entsprechenden Bauräume durch die Tür.

Gemäß einer bevorzugten Ausführungsform der Erfindung sind alle drei Bauräume, also sowohl der erste Verriegelungsbauraum, der zweite Verriegelungsbauraum als auch der Elektronikbauraum , als in sich abgeschlossene Räume ausgeführt. Die beiden Verriegelungsbauräume erstrecken sich dabei zu beiden Seiten der Tür. Der Elektronikbauraum ist ausschließlich im Verschlußgehäuse, d. h. an der Türaußenseite angeordnet.

Gemäß einer bevorzugten Ausführungsform der Erfindung besteht die einzige Verbindung des zweiten Verriegelungsbauraums zu dem türinnenseitigen Raumvolumen aufgrund des durch die Abdeckung aus dem zweiten Verriegelungsbauraum herausgeführten Anschlußkabels.

Gemäß einer bevorzugten Ausführungsform der Erfindung besteht die einzige Verbindung zwischen dem ersten Verriegelungsbauraum und dem türinnenseitigen Raumvolumen aufgrund der durch das Vorreibergehäuse aus dem ersten Verriegelungsbauraum herausgeführten Schließdorn der ersten Verriegelungseinrichtung. Vorzugsweise ist auch der Schließdorn abgedichtet, um die gewünschte Schutzklasse (z.B. IP65) zu erreichen.

Gemäß einer bevorzugten Ausführungsform der Erfindung weist die zweite Verriegelungseinrichtung einen nahe des Freiendes des Schwenkhebelgriffs an dem Schwenkhebelgriff festgelegten Schließzylinder mit einer beweglichen, drehbaren Schließnase auf, die verschiedene Drehstellungen, darunter eine Verschlußstellung und wenigstens eine davon verschiedene Öffnungsstellung einnehmen kann. Mit Hilfe dieses Zylinderschlosses ist der Schwenkhebel an seinem freien Ende in dem Verschlußgehäuse verriegelbar.

Gemäß einer bevorzugten Ausführungsform der Erfindung ist wenigstens ein Sensor zur Bestimmung des Schließzustands des Schließzylinders vorgesehen, insbesondere zur Bestimmung, ob sich die Schließnase des Schließzylinders in einer Verschlußstellung befindet, oder zur Bestimmung, ob sich die Schließnase in einer Öffnungsstellung befindet. Dieser Sensor befindet sich vorzugsweise in dem zweiten äußeren Bauraum. Vorteilhafterweise handelt es sich bei dem Sensor um einen optischen Sensor. Es hat sich dabei eine Ausführungsform als besonders vorteilhaft erwiesen, bei welcher der Sensor, vorzugsweise mitsamt einer Sensorplatine, auf der sich der Sensor befindet, in ein geeignetes, für die Zwecke des optischen Sensors durchsichtiges Hüllenmaterial eingegossen und damit wasserdicht abgedichtet ist. Anstelle eine optischen Sensors kann auch ein anderer geeigneter Sensor verwendet werden, wie beispielsweise ein Hall-Sensor.

Gemäß einer bevorzugten Ausführungsform der Erfindung ist die Verschlußbaugruppe derart ausgeführt, daß der Schwenkhebelgriff in seine Ruhestellung zurückgeführt werden kann, auch wenn der Verschlußschieber aus Sicherheitsgründen unmittelbar nach dem Entriegeln der ersten Verschlußeinrichtung automatisch wieder in seine Sperrstellung gebracht wurde. Der Schwenkhebelgriff kann somit immer in seine Ruhestellung gebracht werden, unabhängig davon, auf welche Weise das Schloß geöffnet wurde.

Gemäß einer bevorzugten Ausführungsform der Erfindung ist der Verschlußschieber bei einem Einklappen des Schwenkhebelgriffs in dessen Ruhestellung durch eine Beaufschlagung mit der Schließnase des Schließzylinders gegen die Kraft eines auf den Verschlußschieber wirkenden Federelements aus seiner Sperrstellung in eine von der Freigabestellung verschiedene Übergangsstellung bewegbar, in welche Übergangsstellung der Verschlußschieber ein Einklappen des Schwenkhebelgriffs in dessen Ruhestellung nicht sperrt. Aufgrund des Federelements nimmt der Verschlußschieber anschließend selbsttätig seine Sperrstellung ein, wenn sich der Schwenkhebelgriff in seiner Ruhestellung befindet. Anders ausgedrückt erfolgt eine Bewegung des Verschlußschiebers aus seiner Sperrstellung heraus, indem die Schließnase des Schließzylinders beim Einklappen des Griffs den Verschlußschieber aus dessen Sperrstellung verdrängt, so daß sich der Verschlußschieber über die Schließnase hinwegbewegt und seine Sperrstellung selbsttätig erneut einnimmt, sobald sich der Schwenkhebelgriff in der Ruhestellung befindet.

Gemäß einer bevorzugten Ausführungsform der Erfindung ist der zweite äußere Bauraum gegenüber dem dritten äußeren Bauraum abgedichtet. Zugleich ist der zweite innere Bauraum gegenüber dem übrigen Raumvolumen auf der dem Verschlußgehäuse gegenüberliegenden Seite der Tür abgedichtet. Beide Abdichtungen entsprechend mindestens der Schutzart IP54, vorzugsweise der Schutzart IP65. Auf diese Weise kann durch den Schließzylinder in den von dem zweiten äußeren Bauraum und dem zweiten inneren Bauraum gebildeten zweiten Verriegelungsbauraum eintretende Feuchtigkeit weder in das Raumvolumen hinter der Tür noch in den dritten äußeren Bauraum, der als Elektronikbauraum dient, eindringen.

Weitere vorteilhafte Ausführungen der Erfindung werden in Verbindung mit einem Ausführungsbeispiel der Erfindung nachfolgend anhand der Zeichnungen näher erläutert. Hierbei zeigen:
- Fig. 1: eine Verschlußbaugruppe mit herausgeklapptem und verschwenktem Griff,
- Fig. 2: die Verschlußbaugruppe von vorn,
- Fig. 3: die Verschlußbaugruppe von der Seite,
- Fig. 4: die Verschlußbaugruppe von hinten (verschlossen),
- Fig. 5: die Verschlußbaugruppe von hinten (ohne Abdeckungen),
- Fig. 6: die Verschlußbaugruppe in einer Explosionsdarstellung,
- Fig. 7: eine Schnittdarstellung der Verschlußbaugruppe entlang der Linie AA in Fig. 4,

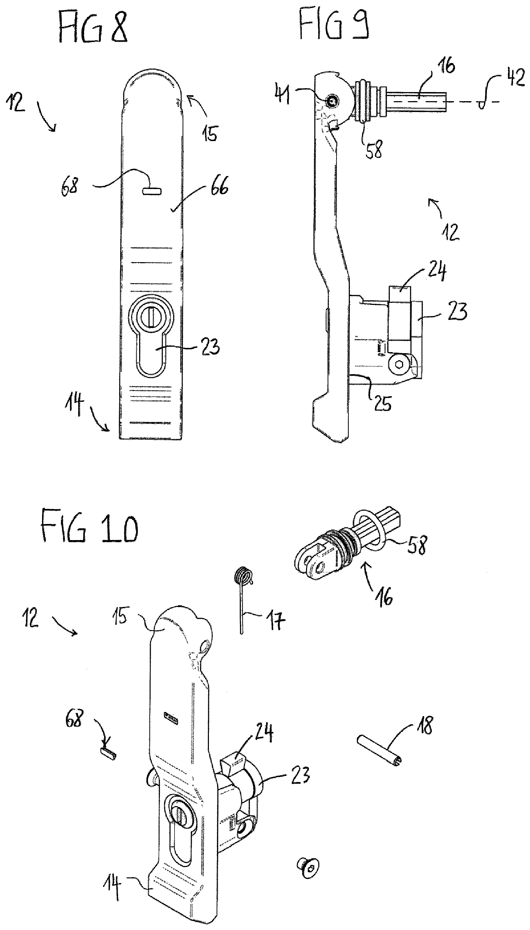

- Fig. 8: der Griff von vorn,
- Fig. 9: der Griff von der Seite,
- Fig. 10: der Griff in einer Explosionsdarstellung,
- Fig. 11: die elektromechanische Einheit von vorn,
- Fig. 12: die elektromechanische Einheit von der Seite,
- Fig. 13: die elektromechanische Einheit in einer Explosionsdarstellung.

Sämtliche Figuren zeigen die Erfindung nicht maßstabsgerecht, dabei lediglich schematisch und nur mit ihren wesentlichen Bestandteilen. Gleiche Bezugszeichen entsprechen dabei Elementen gleicher oder vergleichbarer Funktion.

Räumliche Angaben, wir "vorn" oder "hinten" bzw. "oben" oder "unten" beziehen sich auf den bestimmungsgemäßen bzw. den in den Figuren dargestellten Verwendungszustand des Verschlusses.

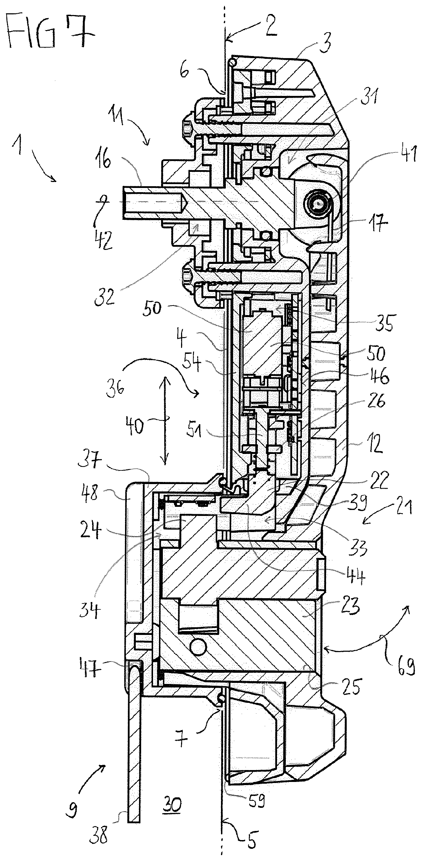

Die erfindungsgemäße elektromechanische Verschlußbaugruppe 1 dient zum Verschließen einer Tür 2, beispielsweise der Tür 2 eines Serverschrankes. Die Verschlußbaugruppe 1 umfaßt ein Verschlußgehäuse 3, das mit seiner Unterseite 4 unter Verwendung einer Ringdichtung 59 auf eine Seite 5 der Tür 2, hier auf ein Türblatt, aufsetzbar ist, dabei vorzugsweise die äußeren Ränder einer oder mehrerer in der Tür 2 vorgesehener Montageöffnungen 6, 7 überdeckend. Das Türblatt ist lediglich in Fig. 7 angedeutet. Es weist zwei Standard-Montageöffnungen 6, 7 mit den Abmessungen 50 mm x 25 mm auf. Die Baugruppe 1 ist aber auch an Türen mit einer einzelnen Standard-Montageöffnung 25 mm x 150 mm montierbar und damit zu den beiden gängigsten Lochbildern kompatibel.

Die Verschlußbaugruppe 1 umfaßt eine erste Verriegelungseinrichtung 11 zum Verriegeln der Tür 2, wobei die erste Verriegelungseinrichtung 11 einen Schwenkhebelgriff 12 aufweist, der in seiner Ruhestellung in einer Aufnahme 13 des Verschlußgehäuses 3 aufgenommen ist.

Die Verschlußbaugruppe 1 umfaßt eine zweite Verriegelungseinrichtung 21 zum Verriegeln des Schwenkhebelgriffs 12, wobei diese zweite Verriegelungseinrichtung 21 ein elektromotorisch betätigbares Verriegelungselement 22 aufweist.

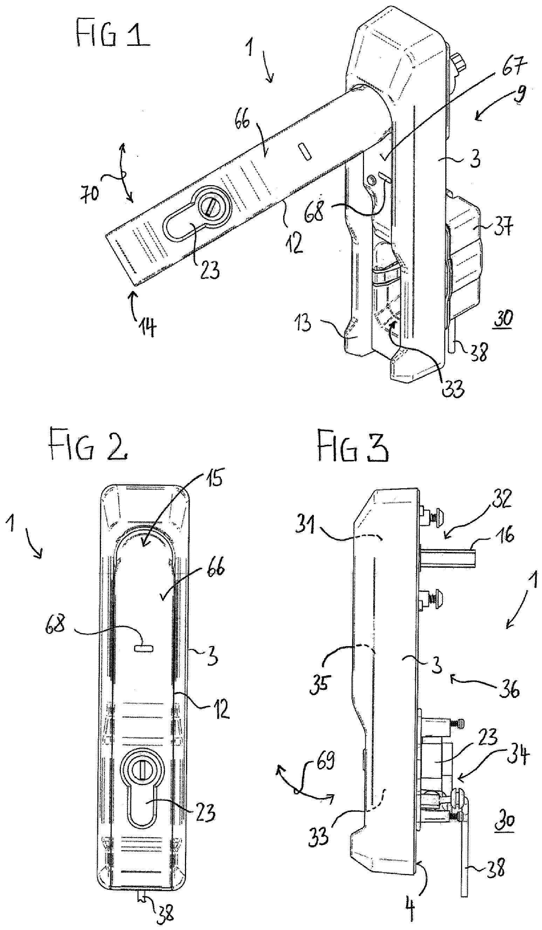

Teile der ersten Verriegelungseinrichtung 11 ragen über die Unterseite 4 des Verschlußgehäuses 3 hinaus, so daß Teile der ersten Verriegelungseinrichtung 11 sowohl in einem ersten äußeren Bauraum 31 innerhalb des Verschlußgehäuses 3 als auch in einem mit dem ersten äußeren Bauraum 31 in Verbindung stehenden ersten inneren Bauraum 32 auf der dem Verschlußgehäuse 3 gegenüberliegenden Seite 30 der Tür 2 angeordnet sind, siehe Fig. 3.

Teile der zweiten Verriegelungseinrichtung 21 ragen über die Unterseite 4 des Verschlußgehäuses 3 hinaus, so daß Teile der zweiten Verriegelungseinrichtung 21 sowohl in einem zweiten äußeren Bauraum 33 innerhalb des Verschlußgehäuses 3 als auch in einem mit dem zweiten äußeren Bauraum 33 in Verbindung stehenden zweiten inneren Bauraum 34 auf der dem Verschlußgehäuse 3 gegenüberliegenden Seite 30 der Tür 2 angeordnet sind.

Teile der zweiten Verriegelungseinrichtung 21 sind in einem dritten äußeren Bauraum 35 innerhalb des Verschlußgehäuses 3 angeordnet, welcher dritte äußere Bauraum 35 zwischen dem ersten äußeren Bauraum 31 und dem zweiten äußeren Bauraum 33 angeordnet ist. Dabei ragen die in dem dritten äußeren Bauraum 35 angeordneten Teile der zweiten Verriegelungsvorrichtung 21 nicht über die Unterseite 4 des Verschlußgehäuses 3 hinaus, so daß sie keinen Bauraum auf der dem Verschlußgehäuse 3 gegenüberliegenden Seite 30 der Tür 2 beanspruchen, insbesondere keinen Bauraum zwischen dem ersten inneren Bauraum 32 und dem zweiten inneren Bauraum 34. Hierdurch verbleibt auf der dem Verschlußgehäuse 3 gegenüberliegenden Seite 30 der Tür 2 ein Freiraum 36 zwischen dem ersten inneren Bauraum 32 und dem zweiten inneren Bauraum 34, der eine Montage der Verschlußbaugruppe 1 sowohl bei einer Tür 2 mit einer einzigen durchgehenden Montageöffnung (nicht abgebildet), insbesondere mit einer rechteckförmigen Montageöffnung mit einer Breite von 25 mm und einer Länge von 150 mm, als auch bei einer Tür 2 mit zwei Montageöffnungen 6, 7 erlaubt, insbesondere mit zwei senkrecht zueinander ausgerichteten und in einem Abstand von 50 mm angeordneten, rechteckförmigen Montageöffnungen 6, 7 mit einer Breite von 25 mm und mit einer Länge von 50 mm. Die beiden Montageöffnungen 6, 7 erlauben dabei sowohl die Aufnahme des ersten Verriegelungsbauraums, der gemeinsam von dem ersten äußeren Bauraum 31 und dem ersten inneren Bauraum 32 gebildet wird, als auch die Aufnahme des zweiten Verriegelungsbauraums, der gemeinsam von dem zweiten äußeren Bauraum 33 und dem zweiten inneren Bauraum 34 gebildet wird, in der Tür 2 bzw. das Hindurchführen der entsprechenden Bauräume durch die Tür 2.

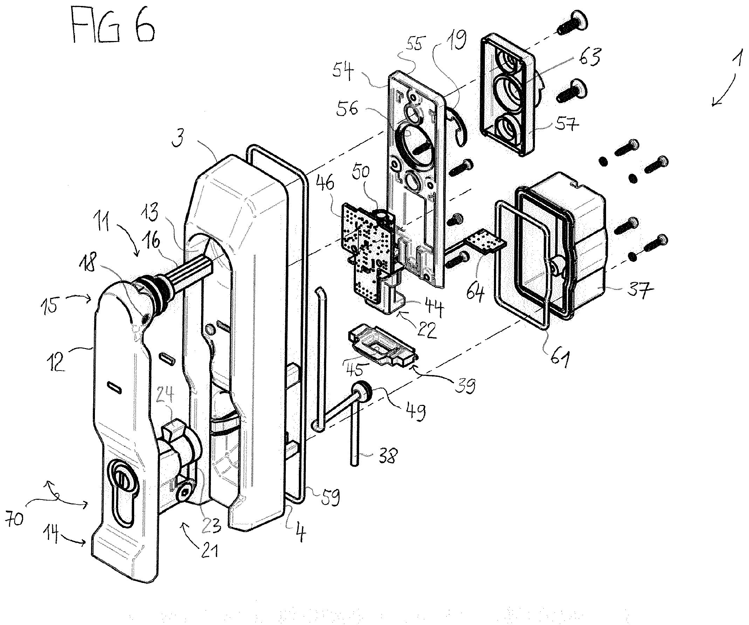

Der Schwenkhebelgriff 12 der ersten Verriegelungseinrichtung 11 ist für ein Entriegeln der Tür 2 mit seinem Freiende 14 aus einer Ruhestellung von dem Verschlußgehäuse 3 weg in eine Schwenkstellung ausklappbar und in dieser Schwenkstellung von einer Verriegelungsposition in eine Entriegelungsposition und zurück verschwenkbar. Die Aus- und Einklapprichtung 69 um die Schwenkachse 41 ist in Fig. 3, die Schwenkrichtung 70 um die Schwenkachse 42 in Fig. 1 und 6 angegeben.

Die erste Verriegelungseinrichtung 11 umfaßt einen Schließdorn 16. An dem Schließdorn 16 ist beispielsweise eine Schließzunge (nicht dargestellt) drehfest befestigt oder aber ein Ritzel (nicht dargestellt) zum Antrieb einer Zahnstange oder einer gezahnten Verriegelungsstange eines Stangenschlosses. Dabei kann die Schließzunge so ausgeführt sein, daß sie in der Verriegelungsposition des Griffs 12 hinter eine Abkantung (nicht abgebildet) des Türrahmens liegt und dadurch das Türblatt festhält.

Der Schließdorn 16 ist unter Verwendung eines geeigneten Federelements 17 mit Hilfe eines Spannstiftes 18 an dem Festende 15 des Griffs 12 fixiert, wobei der Spannstift 18 zugleich die erste Schwenkachse 41 des Griffs 12 relativ zu dem Schließdorn 16 definiert, so daß der Griff 12 am Schließdorn 16 schwenkbar angelenkt ist. Auf diese Weise kann der Griff 12 aus seiner Ruhestellung in der Aufnahme 13 des Gehäuses 3 in seine Schwenkstellung ausgeklappt und wieder zurück eingeklappt werden. In seiner Schwenkstellung ist dann durch ein Verschwenken des Griffs 12 zwischen einer Verriegelungsposition und einer Entriegelungsposition, wie sie in Fig. 1 gezeigt wird, der Schließdorn 16 und mit diesem die darin befestigte Schließzunge oder dergleichen um eine senkrecht zu der ersten Schwenkachse 41 liegende zweite Schwenkachse 42 drehbar, welche durch die Mittellängsachse des Schließdorns 16 definiert wird. In Fig. 6 abgebildet ist eine Sicherungsscheibe 19, welche den Griff 12 im Gehäuse 3 hält.

Die zweite Verriegelungseinrichtung 21 weist einen nahe des Freiendes 14 des Schwenkhebelgriffs 12 an dem Schwenkhebelgriff 12 festgelegten Schließzylinder 23 mit einer beweglichen, drehbaren Schließnase 24 auf, die verschiedene Drehstellungen, darunter eine Verschlußstellung und wenigstens eine davon verschiedene Öffnungsstellung einnehmen kann. Mit Hilfe dieses Zylinderschlosses ist der Schwenkhebel 12 an seinem freien Ende 14 in dem Verschlußgehäuse 3 verriegelbar. Bei dem Schließzylinder 23 handelt es sich vorzugsweise um einen Profilzylinder, insbesondere einen DIN 10/30 Profilhalbzylinder.

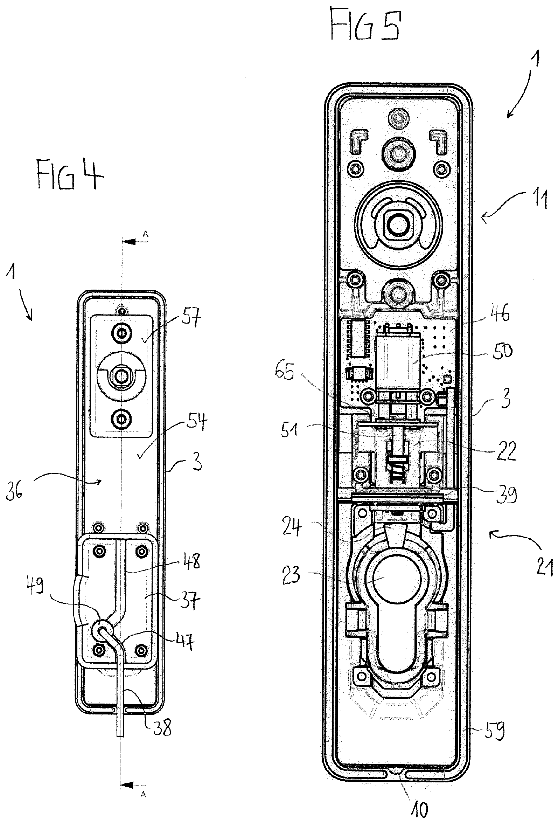

Das Verriegelungselement 22 der zweiten Verriegelungseinrichtung 21 ist in dem illustrierten Beispiel als ein von einer Sperrstellung in eine Freigabestellung und zurück bewegbarer Verschlußschieber ausgeführt, der in seiner Sperrstellung ein Ausklappen des Schwenkhebelgriffs 12 aus dessen Ruhestellung mechanisch sperrt, wenn die Schließnase 24 des Schließzylinders 23 in der Verschlußstellung angeordnet ist. In den Fig. 5 und 7 ist die Freigabestellung des Verschlußschiebers 22 dargestellt.

Der Griff 12 weist eine Fassung 25 für den Schließzylinder 23 auf. Der an dem Griff 12 befestigte Schließzylinder 23 wird mit dem Griff 12 ausgeklappt und auch verschwenkt sowie wieder in die Ruhestellung eingeklappt. Beim Ausklappen des Griffs 12 in seine Schwenkstellung wird der Schließzylinder 23 aus dem zweiten Verriegelungsbauraum vollständig herausgeführt. Umgekehrt wird beim Einklappen des Griffs 12 in die Aufnahme 13 des Verschlußgehäuses 3 der Schließzylinder 23 wieder in den zweiten Verriegelungsbauraum eingeführt, wobei in der Ruhestellung des Griffs 12 der vordere Teil des Schließzylinders 23 in dem zweiten äußeren Bauraum 33 und der hintere Teil in dem zweiten inneren Bauraum 34 angeordnet ist.

Der Verschlußschieber 22 ist mit seinem einen, oberen Ende 28 in dem dritten äußeren Bauraum 35 angeordnet und wirkt dort mit einer auf der Motorwelle 51 angeordneten Mitnehmer 26 in Gestalt einer Mutter zusammen, die in einer entsprechenden Ausnehmung 27 des Verschlußschiebers 22 anliegend den Verschlußschieber 22 linear verfährt. Das gegenüberliegende, untere Ende 29 des Verschlußschiebers 22 ist nach Art eines Fußes L-förmig ausgebildet, wobei die Stirnfläche 43 der Auskragung 44 als Anschlag für die Schließnase 24 des Schließzylinders 23 und damit zur Verwirklichung der Sperrfunktion dient. Während der sich in Verschieberichtung 40 erstreckende Grundkörper 53 des Verschlußschiebers 22 in den äußeren Bauräumen 33, 35 befindet, erstreckt sich die Auskragung 44 aus dem zweiten äußeren Bauraum 33 in den zweiten inneren Bauraum 34.

Der zweite äußere Bauraum 33 ist gegenüber dem dritten äußeren Bauraum 35 abgedichtet. Zugleich ist der zweite innere Bauraum 34 gegenüber dem übrigen Raumvolumen 9 auf der dem Verschlußgehäuse 3 gegenüberliegenden Seite 30 der Tür 2 abgedichtet. Beide Abdichtungen entsprechend der Schutzart IP54, vorzugsweise der Schutzart IP65. Auf diese Weise kann durch den Schließzylinder 23 in den von dem zweiten äußeren Bauraum 33 und dem zweiten inneren Bauraum 34 gebildeten zweiten Verriegelungsbauraum eintretende Feuchtigkeit weder in das Raumvolumen 9 hinter der Tür 2 noch in den dritten äußeren Bauraum 35, der als Elektronikbauraum dient, eindringen. In den zweiten Verriegelungsbauraum durch den Schließzylinder 23 eingetretenes Wasser kann durch eine an der Unterseite des zweiten äußeren Bauraums 33 vorgesehen Öffnung 10 wieder aus der Baugruppe 1 austreten.

Zum Zweck der beschriebenen Abdichtung ist der zweite innere Bauraum 34 von einer Abdeckung 37 umfaßt, die den zweiten inneren Bauraum 34 von dem übrigen Raumvolumen 9 auf der dem Verschlußgehäuse 3 gegenüberliegenden Seite 30 der Tür 2 abkapselt. Diese mit Hilfe einer weiteren Ringdichtung 61 abgedichtete Abdeckung 37 ist asymmetrisch ausgeführt derart, daß - je nach Anordnung - die Stangen eines Stangenschlosses an einer Seite der Abdeckung 37 vorbeigeführt werden kann. Hierfür kann die Abdeckung 37 in zwei Lagen, um 180° gedreht, montiert werden. Die Abdeckung 37 weist verschiedene Kabelführungen 47, 48 auf, so daß das durch eine die Abdeckung 37 nach außen abdichtende Durchführungstülle 49 geführte Anschlußkabel 38 sowohl nach oben als auch nach unten weggeführt werden kann. Die Kabelführung 47, 48 dient zugleich als Zugentlastung für das Anschlußkabel 38.

Zum Zweck der beschriebenen Abdichtung ist zwischen dem zweiten äußeren Bauraum 33 und dem dritten äußeren Bauraum 35 ein Dichtelement 39 angeordnet, das einen abgedichtet Durchgang für wenigstens einen Teil der zweiten Verriegelungseinrichtung 21 bereitstellt, insbesondere für den Verschlußschieber 22. Der Verschlußschieber 22 ist mit anderen Worten sowohl in dem zweiten äußeren Bauraum 33 als auch in dem dritten äußeren Bauraum 35 angeordnet. Er erstreckt sich durch eine Öffnung 45 des Dichtelements 39 von Bauraum zu Bauraum.

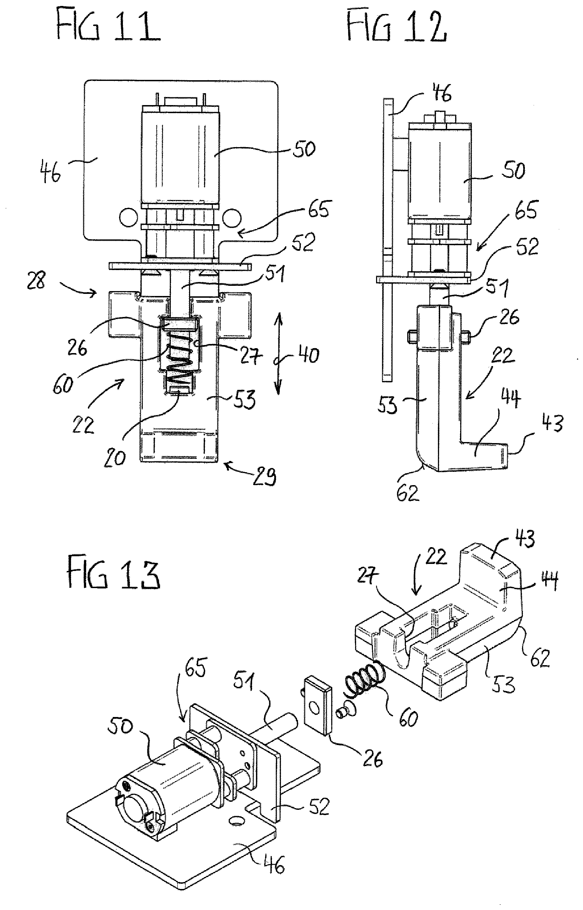

Die zweite Verriegelungseinrichtung 21 umfaßt einen von einer Steuerung (nicht dargestellt) außerhalb der Verschlußbaugruppe 1 ansteuerbaren Elektromotor 50, der in dem dritten äußeren Bauraum 35 angeordnet ist. Das Motorbefestigungsblech 52 ist in den Fig. 11 bis 13 dargestellt. Die Ansteuerung erfolgt insbesondere mit Hilfe von Steuersignalen, die von der Steuerung an eine dem Elektromotor 50 zugordnete Motorplatine 46 übertragen werden. Die Motorwelle 51 ist zur Umwandlung der Drehbewegung der Welle in eine Linearbewegung des Verschlußschiebers 22 mit einem Außengewinde (nicht dargestellt) versehen, wodurch die mit einem Innengewinde (nicht dargestellt) versehene, mit der Motorwelle 51 zusammenwirkende Mutter 26 bewegbar ist, die als Mitnehmer wirkt, um den Verschlußschieber 22 von der Sperrstellung in die Freigabestellung zu bewegen.

Der in dem Elektronikbauraum 35 angebrachte Gleichstrommotor 50 ist aufgrund des sehr begrenzten Bauraums mit einem besonders kleinbauenden Getriebe versehen, das hier als Stirnradgetriebe 65 ausgebildet ist.

Der erste äußere Bauraum 31 und der dritte äußere Bauraum 35 sind mit Hilfe einer gemeinsamen Rückabdeckung 54 verschlossen, deren Außenseite 55 auf diejenige Seite 5 der Tür 2 hin gerichtet ist, auf die das Verschlußgehäuse 3 mit seiner Unterseite 4 aufsetzt. Während die Rückabdeckung 55 den dritten äußeren Bauraum 35 dicht verschließt, weist sie im Bereich des ersten äußeren Bauraums 31 die für die Funktion der ersten Verriegelungseinrichtung 11 benötigten Öffnungen auf, insbesondere eine Öffnung 56 zur Durchführung des Schließdorns 16. Der erste äußere Bauraum 31 und der erste innere Bauraum 32 bilden auf diese Weise gemeinsam den ersten Verriegelungsbauraum. Der erste innere Bauraum 32 ist von einer Abdeckung 57 umfaßt, die den ersten inneren Bauraum 32 von dem übrigen Raumvolumen 9 auf dem Verschlußgehäuse 3 gegenüberliegenden Seite 30 der Tür 2 abkapselt. Die Abdeckung 57 ist dabei in dem gezeigten Beispiel als Vorreibergehäuse ausgeführt. Die Abdeckung 57 weist wiederum eine Öffnung 63 zur Durchführung des Schließdorns 16 auf.

Auf diese Weise sind alle drei Bauräume, also sowohl der erste Verriegelungsbauraum 31, 32, der zweite Verriegelungsbauraum 33, 34 als auch der Elektronikbauraum 35, als in sich abgeschlossene Räume ausgeführt. Die beiden Verriegelungsbauräume erstrecken sich dabei zu beiden Seiten der Tür 2. Der Elektronikbauraum 35 ist ausschließlich im Verschlußgehäuse 3, d. h. an der Türaußenseite 5 angeordnet.

Die einzige Verbindung des zweiten Verriegelungsbauraums 33, 34 zu dem türinnenseitigen Raumvolumen 9 besteht aufgrund des durch die Abdeckung 37 aus dem zweiten Verriegelungsbauraum herausgeführten Anschlußkabels 38.

Die einzige Verbindung zwischen dem ersten Verriegelungsbauraum 31, 32 und dem türinnenseitigen Raumvolumen 9 besteht aufgrund der durch das Vorreibergehäuse 57 aus dem ersten Verriegelungsbauraum herausgeführten Schließdorn 16 der ersten Verriegelungseinrichtung 11. Auch der Schließdorn 16 ist abgedichtet, um die gewünschte Schutzklasse (z.B. IP65) zu erreichen. Zur Abdichtung dient hier ein Dichtungselement 58 in Form eines O-Rings.

Der Verschlußschieber 22 ist bei einem Einklappen des Schwenkhebelgriffs 12 in dessen Ruhestellung durch eine Beaufschlagung mit der Schließnase 24 des Schließzylinders 23 gegen die Kraft eines auf den Verschlußschieber 22 wirkenden Federelements 60 aus seiner Sperrstellung in eine von der Freigabestellung verschiedene Übergangsstellung bewegbar, in welche Übergangsstellung der Verschlußschieber 22 ein Einklappen des Schwenkhebelgriffs 12 in dessen Ruhestellung nicht sperrt. Aufgrund des Federelements 60 nimmt der Verschlußschieber 22 anschließend selbsttätig seine Sperrstellung ein, wenn sich der Schwenkhebelgriff 12 in seiner Ruhestellung befindet. Anders ausgedrückt erfolgt eine Bewegung des Verschlußschiebers 22 aus seiner Sperrstellung heraus, indem die Schließnase 24 des Schließzylinders 23 beim Einklappen des Griffs 12 den Verschlußschieber 22 aus dessen Sperrstellung verdrängt, so daß sich der Verschlußschieber 22 über die Schließnase 24 hinwegbewegt und seine Sperrstellung selbsttätig erneut einnimmt, sobald sich der Schwenkhebelgriff 12 in der Ruhestellung befindet. Auf diese Weise kann der Schwenkhebelgriff 12 in seine Ruhestellung zurückgeführt werden, auch wenn der Verschlußschieber 22 aus Sicherheitsgründen unmittelbar nach dem Entriegeln der ersten Verschlußeinrichtung 21 automatisch wieder in seine Sperrstellung gebracht wurde. Der Schwenkhebelgriff 12 kann somit immer in seine Ruhestellung gebracht werden, unabhängig davon, auf welche Weise das Schloß geöffnet wurde.

Die Rückholfeder 60, mit der der Verschlußschieber 22 aus seiner Übergangsstellung zurück in seine Sperrstellung gebracht wird, um die beschriebene Einrastfunktion zu verwirklichen, ist hier als Schraubendruckfeder ausgeführt, die über der Motorwelle 51 angebracht ist und sich mit ihrem einen Federende an der Mutter 26 sowie mit ihrem anderen Federende an dem Verschlußschieber 22 abstützt, zu welchem Zweck dort ein Federdom 20 vorgesehen ist.

Um das Herausbewegen des Verschlußschiebers 22 aus der Sperrstellung in die Übergangsstellung zu erleichtern, weist der Verschlußschieber 22 an seiner äußeren Unterkante eine Anlaufschräge 62 für die Schließnase 24 auf.

In dem zweiten äußeren Bauraum 33 ist nahe der Schließnase 24 ein Sensor zur Bestimmung des Schließzustands des Schließzylinders 23 angeordnet, insbesondere zur Bestimmung, ob sich die Schließnase 24 in der Verschlußstellung befindet, oder zur Bestimmung, ob sich die Schließnase 24 in einer Öffnungsstellung befindet.

Als Sensor wird vorzugsweise ein optischer Sensor verwendet, der sich auf einer Sensorplatine 64 befindet, die in eine geeignete Halterung im inneren des zweiten äußeren Bauraums 33 eingeschoben wird. Die Platine 64 des Sensors ist in ein geeignetes für die Zwecke des optischen Sensors durchsichtiges Hüllenmaterial eingegossen und damit wasserdicht abgedichtet. Zum Anschließen der Sensorplatine 64 an die Hauptplatine 46 im Elektronikbauraum 35 wird ein flexibler Teil der Platine 64 durch ein den zweiten äußeren Bauraum 33 von dem dritten äußeren Bauraum 35 abtrennendes Dichtelement hindurchgeführt. Dabei kann es sich um dasjenige Dichtelement 39 handeln, welches auch den Durchgang für den Verschlußschieber 22 aufweist.

In dem zweiten äußeren Bauraum 33 ist optional auch ein Sensor (nicht abgebildet) zur Bestimmung des Zustands des Verriegelungselements 22 angeordnet, insbesondere zur Bestimmung, ob sich das Verriegelungselement 22 in seiner Sperrstellung befindet.

Sowohl der Sensor für die Position der Schließnase 24 als auch der Sensor für die Position des Verschlußschiebers 22 sind auf geeignete Weise abgedichtet, insbesondere gegen Feuchtigkeit. Die Übertragung der Sensordaten an die Platine 46 und/oder an die Steuerung erfolgt vorzugsweise zum Zweck der Überwachung von Status und Funktion des Verschlusses und seiner Komponenten mit Hilfe eines innerhalb der Verschlußbaugruppe 1 auf geeignete Weise angeschlossenen und aus der Verschlußbaugruppe 1 herausgeführten Kabels 38. Dabei handelt es sich vorzugsweise um das einzige Anschlußkabel der Baugruppe 1, insbesondere in Form eines kombinierten Strom- und Datenkabels, das über einen Anschluß an eine externe Stromversorgung (z.B. 10 Volt oder 24 Volt) zugleich die Baugruppe 1 mit Strom versorgt. Das Kabel 38 wird von dem dritten äußeren Bauraum 35 in den zweiten äußeren Bauraum 33 und aus dem zweiten äußeren Bauraum 33 über den zweiten inneren Bauraum 34 durch die Abdeckung 37 in das Raumvolumen 9 auf der dem Verschlußgehäuse 3 gegenüberliegenden Seite 30 der Tür 2 herausgeführt.

Vorteilhafterweise sind an der Außenseite 66 des Schwenkhebelgriffs 12 sowie an der in der Aufnahme 13 des Verschlußgehäuses 3 angeordneten Vorderwand 67 des dritten äußeren Bauraums 35 signaltechnisch mit der Platine 46 verbundene optische Anzeigen 68 vorgesehen, hier in Form von LEDs zur Status- bzw. Funktionsanzeige der Baugruppe 1 bzw. des Schlosses.

Alle in der Beschreibung, den nachfolgenden Ansprüchen und den Zeichnungen dargestellten Merkmale können sowohl einzeln als auch in beliebiger Kombination miteinander erfindungswesentlich sein. Diese Merkmale bzw. Merkmalskombinationen können jeweils eine selbständige Erfindung begründen, deren Inanspruchnahme ausdrücklich vorbehalten ist.

Bei der Angabe einer eine Erfindung definierenden Merkmalskombination müssen einzelne Merkmale aus der Beschreibung eines Ausführungsbeispiels nicht zwingend mit einem oder mehreren oder allen anderen in der Beschreibung dieses Ausführungsbeispiels angegebenen Merkmalen kombiniert werden; diesbezüglich ist jede Unterkombination von Merkmalen eines oder mehrerer Ausführungsbeispiele ausdrücklich mitoffenbart.

Außerdem können gegenständliche Merkmale der Vorrichtung umformuliert als Verfahrensmerkmale Verwendung finden und Verfahrensmerkmale können umformuliert als gegenständliche Merkmale der Vorrichtung Verwendung finden. Auf diese Weise umformulierte Merkmale sind implizit mitoffenbart.

### Bezugszeichenliste

- 1: Verschlußbaugruppe
- 2: Tür
- 3: Verschlußgehäuse
- 4: Gehäuseunterseite
- 5: Türaußenseite
- 6: erste Montageöffnung 25x50mm
- 7: zweite Montageöffnung 25x50mm
- 8: Türinnenseite
- 9: Raumvolumen
- 10: Austrittsöffnung
- 11: erste Verriegelungseinrichtung
- 12: Schwenkhebelgriff
- 13: Aufnahme
- 14: Freiende des Griffs
- 15: Festende des Griffs
- 16: Schließdorn
- 17: Federelement
- 18: Spannstift
- 19: Sicherungsscheibe
- 20: Federdom
- 21: zweite Verriegelungseinrichtung
- 22: Verriegelungselement, Verschlußschieber
- 23: Schließzylinder
- 24: Schließnase
- 25: Fassung
- 26: Mitnehmer, Mutter
- 27: Ausnehmung
- 28: oberes Verschlußschieberende
- 29: unteres Verschlußschieberende
- 30: gegenüberliegende Seite der Tür
- 31: erster äußerer Bauraum
- 32: erster innerer Bauraum
- 33: zweiter äußerer Bauraum
- 34: zweiter innerer Bauraum
- 35: dritter äußerer Bauraum
- 36: Freiraum
- 37: Abdeckung
- 38: Anschlußkabel
- 39: Dichtelement
- 40: Verschieberichtung
- 41: erste Schwenkachse
- 42: zweite Schwenkachse
- 43: Stirnfläche
- 44: Auskragung
- 45: Dichtelementöffnung
- 46: Motorplatine, Hauptplatine
- 47: Kabelführung
- 48: Kabelführung
- 49: Durchführungstülle
- 50: Motor
- 51: Motorwelle
- 52: Motorbefestigungsblech
- 53: Grundkörper
- 54: Rückabdeckung
- 55: Außenseite
- 56: Durchführungsöffnung
- 57: Abdeckung, Vorreibergehäuse
- 58: Dichtungselement, O-Ring
- 59: Ringdichtung
- 60: Federelement
- 61: Ringdichtung
- 62: Anlaufschräge
- 63: Durchführungsöffnung
- 64: Sensorplatine
- 65: Getriebe
- 66: Griffaußenseite
- 67: Vorderwand
- 68: LED
- 69: Aus- und Einklapprichtung
- 70: Schwenkrichtung

## Patentansprüche

1. Elektromechanische Verschlußbaugruppe (1) für eine Tür (2),
mit einem Verschlußgehäuse (3), das mit seiner Unterseite (4) auf eine Seite (5) der Tür (2) aufsetzbar ist, dabei vorzugsweise die äußeren Ränder einer oder mehrerer in der Tür (2) vorgesehener Montageöffnungen (6, 7) überdeckend,
mit einer ersten Verriegelungseinrichtung (11) zum Verriegeln der Tür (2), wobei die erste Verriegelungseinrichtung (11) einen Schwenkhebelgriff (12) aufweist, der vorzugsweise in seiner Ruhestellung in einer Aufnahme (13) des Verschlußgehäuses (3) aufgenommen ist, und
mit einer zweiten Verriegelungseinrichtung (21) zum Verriegeln des Schwenkhebelgriffs (12), wobei diese zweite Verriegelungseinrichtung (21) ein elektromotorisch betätigbares Verriegelungselement (22) aufweist,
wobei Teile der ersten Verriegelungseinrichtung (11) über die Unterseite (4) des Verschlußgehäuses (3) hinausragen, so daß Teile der ersten Verriegelungseinrichtung (11) sowohl in einem ersten äußeren Bauraum (31) innerhalb des Verschlußgehäuses (3) als auch in einem mit dem ersten äußeren Bauraum (31) in Verbindung stehenden ersten inneren Bauraum (32) auf der dem Verschlußgehäuse (3) gegenüberliegenden Seite (30) der Tür (2) angeordnet sind,
wobei Teile der zweiten Verriegelungseinrichtung (21) über die Unterseite (4) des Verschlußgehäuses (3) hinausragen, so daß Teile der zweiten Verriegelungseinrichtung (21) sowohl in einem zweiten äußeren Bauraum (33) innerhalb des Verschlußgehäuses (3) als auch in einem mit dem zweiten äußeren Bauraum (33) in Verbindung stehenden zweiten inneren Bauraum (34) auf der dem Verschlußgehäuse (3) gegenüberliegenden Seite (30) der Tür (2) angeordnet sind,
wobei Teile der zweiten Verriegelungseinrichtung (21) in einem dritten äußeren Bauraum (35) innerhalb des Verschlußgehäuses (3) angeordnet sind, welcher dritte äußere Bauraum (35) zwischen dem ersten äußeren Bauraum (31) und dem zweiten äußeren Bauraum (33) angeordnet ist, wobei die in dem dritten äußeren Bauraum (35) angeordneten Teile der zweiten Verriegelungsvorrichtung (21) nicht über die Unterseite (4) des Verschlußgehäuses (3) hinausragen, so daß sie keinen Bauraum auf der dem Verschlußgehäuse (3) gegenüberliegenden Seite (30) der Tür (2) beanspruchen, wodurch auf der dem Verschlußgehäuse (3) gegenüberliegenden Seite (30) der Tür (2) ein Freiraum (36) zwischen dem ersten inneren Bauraum (32) und dem zweiten inneren Bauraum (34) verbleibt, der eine Montage der Verschlußbaugruppe (1) sowohl bei einer Tür (2) mit einer einzigen durchgehenden Montageöffnung, insbesondere mit einer rechteckförmigen Montageöffnung mit einer Breite von 25 mm und einer Länge von 150 mm, als auch bei einer Tür (2) mit zwei Montageöffnungen (6, 7) erlaubt, insbesondere mit zwei senkrecht zueinander ausgerichteten und in einem Abstand von 50 mm angeordneten, rechteckförmigen Montageöffnungen (6, 7) mit einer Breite von 25 mm und mit einer Länge von 50 mm.

2. Verschlußbaugruppe (1) nach Anspruch 1,
wobei der Schwenkhebelgriff (12) der ersten Verriegelungseinrichtung (11) für ein Entriegeln der Tür (2) aus einer Ruhestellung von dem Verschlußgehäuse (3) weg in eine Schwenkstellung ausklappbar und in dieser Schwenkstellung von einer Verriegelungsposition in eine Entriegelungsposition und zurück verschwenkbar ist, und
wobei die zweite Verriegelungseinrichtung (21) einen an dem Schwenkhebelgriff (12) festgelegten Schließzylinder (23) mit einer beweglichen Schließnase (24) aufweist, die eine Verschlußstellung und eine davon verschiedene Öffnungsstellung einnehmen kann, und
wobei das Verriegelungselement (22) ein von einer Sperrstellung in eine Freigabestellung und zurück bewegbarer Verschlußschieber ist, der in seiner Sperrstellung ein Ausklappen des Schwenkhebelgriffs (12) aus dessen Ruhestellung mechanisch sperrt, wenn die Schließnase (24) des Schließzylinders (23) in der Verschlußstellung angeordnet ist.

3. Verschlußbaugruppe (1) nach Anspruch 1 oder 2, wobei der zweite äußere Bauraum (33) gegenüber dem dritten äußeren Bauraum (35) abgedichtet ist und/oder wobei der zweite innere Bauraum (34) gegenüber dem übrigen Raumvolumen (9) auf der dem Verschlußgehäuse (3) gegenüberliegenden Seite (30) der Tür (2) abgedichtet ist, und diese Abdichtung der vorzugsweise der Schutzart IP54, ganz besonders vorzugsweise der Schutzart IP65 entspricht.

4. Verschlußbaugruppe (1) nach Anspruch 3, wobei der zweite innere Bauraum (34) von einer den zweiten inneren Bauraum (34) von dem übrigen Raumvolumen (9) auf der dem Verschlußgehäuse (3) gegenüberliegenden Seite (30) der Tür (2) abkapselnden Abdeckung (37) umfaßt ist.

5. Verschlußbaugruppe (1) nach Anspruch 3 oder 4, wobei zwischen dem zweiten äußeren Bauraum (33) und dem dritten äußeren Bauraum (35) ein Dichtelement (39) angeordnet ist, das einen abgedichtet Durchgang (45) für wenigstens einen Teil der zweiten Verriegelungseinrichtung (21) bereitstellt, insbesondere für das Verriegelungselement (22).

6. Verschlußbaugruppe (1) nach einem der Ansprüche 1 bis 5, wobei die zweite Verriegelungseinrichtung (21) einen vorzugsweise von einer Steuerung außerhalb der Verschlußbaugruppe (1) ansteuerbaren Elektromotor (50) umfaßt, der in dem dritten äußeren Bauraum (35) angeordnet ist, wobei die Motorwelle (51) des Motors (50) mit einem Außengewinde versehen ist, wodurch ein mit einem Innengewinde versehener, mit der Motorwelle (51) zusammenwirkender Mitnehmer (26) bewegbar ist, um das Verriegelungselement (22) zu bewegen.

7. Verschlußbaugruppe (1) nach einem der Ansprüche 1 bis 6, wobei das Verriegelungselement (22) bei einem Einklappen des Schwenkhebelgriffs (12) in dessen Ruhestellung durch eine Beaufschlagung mit der Schließnase (24) des Schließzylinders (23) aus seiner Sperrstellung in eine Übergangsstellung bewegbar ist, in welche Übergangsstellung das Verriegelungselement (22) die Bewegung des Schwenkhebelgriff (12) in dessen Ruhestellung nicht sperrt und das Verriegelungselement (22) selbsttätig seine Sperrstellung einnimmt, wenn sich der Schwenkhebelgriff (12) in seiner Ruhestellung befindet.

8. Verschlußbaugruppe (1) nach einem der Ansprüche 1 bis 7, mit einem in dem zweiten äußeren Bauraum (33) angeordneten Sensor zur Bestimmung des Schließzustands des Schließzylinders (23), insbesondere zur Bestimmung, ob sich die Schließnase (24) in der Verschlußstellung befindet, oder zur Bestimmung, ob sich die Schließnase (24) in einer Öffnungsstellung befindet.

9. Verschlußbaugruppe (1) nach einem der Ansprüche 1 bis 8, mit einem in dem zweiten äußeren Bauraum (33) angeordneten Sensor zur Bestimmung des Zustands des Verriegelungselements (22), insbesondere zur Bestimmung, ob sich das Verriegelungselement (22) in seiner Sperrstellung befindet.

10. Verschlußbaugruppe (1) nach einem der Ansprüche 1 bis 9, wobei die erste Verriegelungseinrichtung (11) ausgebildet ist zur wahlweisen Verbindung mit einem Verriegelungselement in Form eines Riegel oder einer Stange.
